Europäisches Patentamt

European Patent Office

Office européen des brevets

(19)

(11) **EP 0 834 115 B1**

(12) **EUROPÄISCHE PATENTSCHRIFT**

(45) Veröffentlichungstag und Bekanntmachung des Hinweises auf die Patenterteilung:
**18.04.2001 Patentblatt 2001/16**

(21) Anmeldenummer: **96915967.2**

(22) Anmeldetag: **04.06.1996**

(51) Int Cl.$^7$: **G06F 7/50**, G06F 7/52, G06F 7/00

(86) Internationale Anmeldenummer:
**PCT/DE96/00981**

(87) Internationale Veröffentlichungsnummer:
**WO 96/42048 (27.12.1996 Gazette 1996/56)**

(54) **SCHALTUNGSANORDNUNG ZUR REALISIERUNG VON DURCH SCHWELLENWERTGLEICHUNGEN DARSTELLBAREN LOGIKELEMENTEN**

CIRCUIT FOR PRODUCING LOGIC ELEMENTS REPRESENTABLE BY THRESHOLD EQUATIONS

CIRCUIT PERMETTANT DE REALISER DES ELEMENTS LOGIQUES POUVANT ETRE REPRESENTES SOUS FORME D'EQUATIONS DE VALEURS SEUILS

(84) Benannte Vertragsstaaten:
**DE FR GB IT**

(30) Priorität: **09.06.1995 DE 19521089**

(43) Veröffentlichungstag der Anmeldung:
**08.04.1998 Patentblatt 1998/15**

(73) Patentinhaber: **Infineon Technologies AG
81669 München (DE)**

(72) Erfinder:
• **PRANGE, Stefan
D-81476 München (DE)**
• **THEWES, Roland
D-82178 Puchheim (DE)**
• **WOHLRAB, Erdmute
D-81825 München (DE)**
• **WEBER, Werner
D-80637 München (DE)**

(74) Vertreter: **Zedlitz, Peter, Dipl.-Inf. et al
Patentanwalt,
Postfach 22 13 17
80503 München (DE)**

(56) Entgegenhaltungen:
**US-A- 3 950 636**

• **HIDALGO-LOPEZ J A ET AL: "NEW TYPES OF DIGITAL COMPARATORS" 30.April 1995 , 1995 IEEE INTERNATIONAL SYMPOSIUM ON CIRCUITS AND SYSTEMS (ISCAS), SEATTLE, APR. 30 - MAY 3, 1995, VOL. 1, PAGE(S) 29 - 32 , INSTITUTE OF ELECTRICAL AND ELECTRONICS ENGINEERS XP000583173 siehe Seite 29, Spalte 1, Zeile 7 - Zeile 27; Abbildung 1A siehe Seite 30, Spalte 2, Zeile 12 - Seite 31, Spalte 1, Zeile 21; Abbildung 2**
• **ALTA FREQUENZA, MILANO IT, XP002014108**
• **IEICE TRANSACTIONS ON FUNDAMENTALS OF ELECTRONICS, COMMUNICATIONS AND COMPUTER SCIENCES, Bd. E75 - A, Nr. 7, 1.Juli 1992, Seiten 937-943, XP000311791 KYOKO TSUKANO ET AL: "A NEW CMOS NEURON CIRCUIT BASED ON A CROSS-COUPLED CURRENT COMPARATOR STRUCTURE"**
• **TAHERI B A: "CMOS IMPLEMENTATION AND FABRICATION OF THE PSEUDO ANALOG NEURON" 24.Mai 1993 , PROCEEDINGS OF THE INTERNATIONAL SYMPOSIUM ON MULTIPLE VALUED LOGIC, SACRAMENTO, MAY 24 - 27, 1993, NR. SYMP. 23, PAGE(S) 266 - 270 , INSTITUTE OF ELECTRICAL AND ELECTRONICS ENGINEERS XP000400346 siehe Seite 268, Spalte 1, Zeile 6 - Seite 269, Spalte 1, Zeile 2; Abbildungen 6,7**
• **PATENT ABSTRACTS OF JAPAN vol. 10, no. 205 (E-240), 17.Juli 1986 & JP 61 048229 A (SANTETSUKU), 8.März 1986,**

**Beschreibung**

Logikelemente sind Grundbausteine heutiger digitaler Rechenanlagen. Da diese Grundbausteine in digitalen Rechenanlagen häufig Verwendung finden, wirkt sich eine Verbesserung eines Grundbausteins direkt in einer Verbesserung der gesamten Anlagen, in denen dieser Grundbaustein verwendet wird, aus. Besondere Bedeutung für die Leistungsfähigkeit und die Qualität eines solchen Grundbausteins haben vor allem die Anzahl der für die Realisierung des Grundbausteins benötigten Transistoren, die Verlustleistung, die in dem Grundbaustein umgesetzt wird, sowie die Geschwindigkeit dieses Grundbausteins. Auch die Verwendung standardisierter Technologie ist ein wesentlicher Faktor in der Qualitätsbeurteilung eines solchen Grundbausteins.

Bekannt ist die Realisierung logischer Grundschaltungen basierend auf ihrer Funktionsgleichung durch Widerstandstransistorlogik (RTL), durch Diodentransistorlogik (DTL), durch langsame störsichere Logik (LSL) und durch Transistortransistorlogik (TTL), durch emittergekoppelte Logik (ECL), komplementäre MOS-Logik (CMOS) und durch NMOS-Logik (siehe U. Tietze, Ch. Schenk, Halbleiterschaltungstechnik, 9. Auflage, Springer-Verlag, 1990, ISBN 3-540-19475-4, Seiten 201-219). Bekannt ist auch die Verwendung von Neuron-MOS-Transistoren zur Realisierung eines binären Volladdierers (T. Shibata, T. Ohmi: "A functional MOS transistor featuring gate-level weighted sum and threshold operations", IEEE Transactions on Electron Devices, 39, Seiten 1444-1455, 1992). Nachteile dieser bekannten Schaltungsanordnungen sind vor allem darin zu sehen, daß eine im Vergleich zur im weiteren beschriebenen Erfindung erhöhte Anzahl von Transistoren benötigt wird. Auch die Geschwindigkeit bekannter Schaltungsanordnungen ist erheblich geringer als die der erfindungsgemäßen Schaltungsanordnung. Ein bedeutender Nachteil bei der Verwendung von Neuron-MOS-Feldeffekttransistoren liegt darin, daß eine spezielle Technologie (EEPROM oder Analogprozeß) verwendet werden muß.

Aus (J. A. Hidalgo-López et al, New Types of Digital Comparators, IEEE International Symposium on Circuits and Sytems (ISCAS), Vol. 1, S. 29 - 32, April 1995) ist eine Komparatorschaltung bekannt, die zwei mitgekoppelte Inverter-Stufen sowie eine Rücksetzeinheit aufweist. Zwei zu vergleichende elektrische Größen werden an den Ausgängen der Inverter-Stufen zugeführt, an denen auch das Vergleichsergebnis anliegt. Die Source-Anschlüsse beider Inverter-Stufen sind miteinander sowie über einen Takttransistor mit Masse verbunden.

Aus (D. Ferrari und R. Stefanelli, Some new Schemes For Parallel Multipliers, Alta Frequenza, Band 38, No. 11, Seite 843 bis 852, XP 0020141008, 1969) ist eine grundlegende Struktur einer Multipliziererzelle auf Systemebene mit zwei unterschiedlichen Einheiten zur Bildung eines Ausgangs-Übertrags-Bits sowie eines Ausgangs-Summen-Bits bekannt. Es wird grundsätzlich der Einsatz von Resistor-Transistor-Logik (RTL) vorgeschlagen. Die beiden Elemente sind derart miteinander verbunden, daß ein Ausgangssignal eines ersten Elements an einen Eingang des zweiten Elements rückgekoppelt ist. Das rückgekoppelte Ausgangssignal wird am Eingang des zweiten Elements unterschiedlich gewichtet als alle weiteren Eingangssignale.

Grundlagen über einen Neuron-MOS-Inverter sind aus (T. Shibata et al, Neuron-MOS Binary Logic Integrated Circuits - Part 2: Simplifying Techniques Of Circuit Configuration And A Practical Applications, IEEE Transactions on Electron Devices, Vol. 40, No. 6, Seite 974 bis 979, 1993) bekannt.

Der Erfindung liegt das Problem zugrunde, Logikelemente, deren Funktion durch eine Schwellenwertgleichung beschrieben werden kann, unter Vermeidung der Nachteile bekannter Schaltungsanordnungen zu realisieren.

Dieses Problem wird durch die Schaltungsanordnung gemäß Patentanspruch 1 gelöst.

In der geringen Anzahl benötigter Transistoren zur Realisierung einer logischen Grundschaltung liegt ein wesentlicher Vorteil dieser Schaltungsanordnung. Durch die Reduzierung der Anzahl benötigter Transistoren wird auch die benötigte Chipfläche reduziert und eine geringere Gesamtkapazität der Schaltungsanordnung erreicht. Man erreicht außerdem eine erheblich geringere Verlustleistung der Schaltungsanordnung bei hohen Taktraten gegenüber bekannten Schaltungsanordnungen. Auch die Geschwindigkeit der erfindungsgemäßen Schaltungsanordnung wird gegenüber bekannten Schaltungsanordnungen wesentlich erhöht.

Weiterbildungen der Erfindung ergeben sich aus den abhängigen Ansprüchen.

In den Zeichnungen sind bevorzugte Ausführungsbeispiele der Erfindung dargestellt und werden im folgenden näher beschrieben. Es zeigen:

Figur 1    eine Skizze, die das Prinzip der erfindungsgemäßen Schaltungsanordnung zur allgemeinenRealisierung un terschiedlicher Logikelemente, deren Funktion durch Schwellenwertgleichungen beschrieben werden kann, beschreibt;

Figur 2    eine mögliche Realisierung einer Bewertungseinheit, mit der zwei elektrische Größen miteinander verglichen werden;

Figur 3    eine Skizze einer erfindungsgemäßen Schaltungsanordnung zur Realisierung einer Volladdiererzelle, bei der die Eingangspotentiale der Volladdiererzelle sowohl für die Bildung des Ausgangs-Übertrags-Bits als auch für die Bildung des Ausgangs-Summen-Bits vorgesehen sind;

Figur 4     eine Skizze einer erfindungsgemäßen Schaltungsanordnung einer Multipliziererzelle, bei der die Eingangspotentiale der Multiplizierzelle sowohl für die Bildung des Ausgangs-Übertrags-Bits als auch für die Bildung des Ausgangs-Summen-Bits vorgesehen sind;

Figur 5     eine Skizze einer erfindungsgemäßen Schaltungsanordnung zur Realisierung eines Fünffach-ODER-Gatters;

Figur 6     eine Skizze einer vorteilhaften Weiterbildung einer erfindungsgemäßen Schaltungsanordnung einer Multipliziererzelle;

Figur 7     eine Skizze einer erfindungsgemäßen Schaltungsanordnung einer Multipliziererzellemit Carry-Ripple-Addition der Partialprodukte, die in einem Feldmultiplizierer mit Pipelining eingesetzt wird;

Figur 8     eine Skizze, die den Aufbau eines Feldmultiplizierers mit Carry-Ripple-Addition der Partialprodukte und zweidimensionalem Pipelining beschreibt, in der eine erfindungsgemäße Multiplizierzelle verwendet wird;

Figur 9     eine Skizze einer erfindungsgemäßen Schaltungsanordnung einer Multipliziererzelle für invertierte Eingangssignale;

Figur 10     eine Skizze einer erfindungsgemäßen Schaltungsanordnung einer Multipliziererzelle mit Carry-Save-Addition der Partialprodukte, die in einem Feldmultiplizierer mit Pipelining eingesetzt wird;

Figuren 11     a-c Skizzen, in denen beschrieben ist, wie sich die Signale $ona_1$, $ona_2$, und $oa_2$ aus dem Multiplikator-Bit $a_1$ und dem Multiplikanden-Bit $a_2$ ergeben.

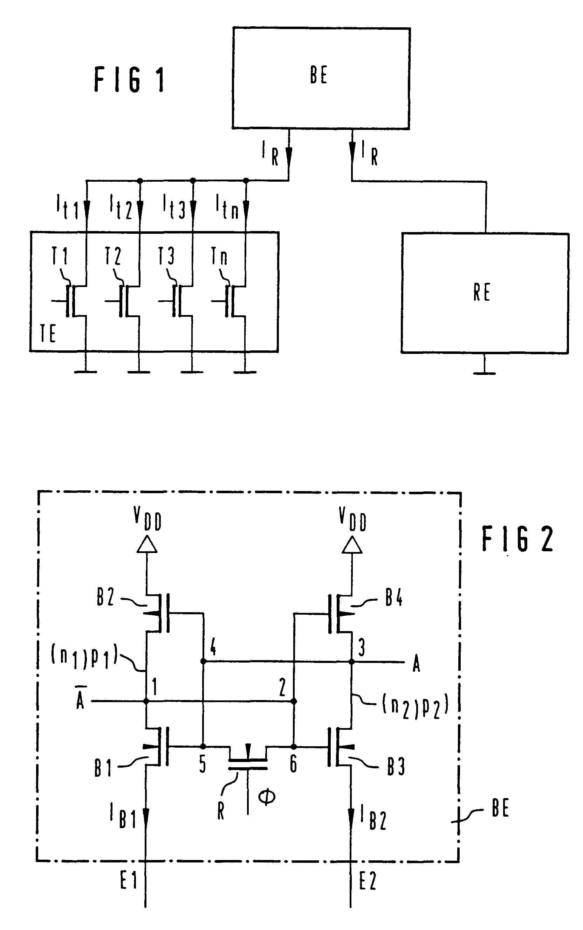

Anhand der Figuren 1 bis 11 a-c wird die Erfindung weiter erläutert.

In Figur 1 ist das Prinzip der Schaltungsanordnung zur Realisierung von Logikelementen, deren Funktion durch Schwellenwertgleichungen beschrieben werden kann, dargestellt. Diese Schaltungsanordnung beschränkt sich nicht auf die im weiteren beschriebenen Ausführungsbeispiele, sondern kann auf jede logische Funktion zur Realisierung in Form einer entsprechend angepaßten erfindungsgemäßen Schaltungsanordnung angewendet werden, die sich durch eine Schwellenwertgleichung beschreiben läßt. Die erfindungsgemäße Schaltungsanordnung hat folgenden prinzipiellen Aufbau:

Eine Transistoreinheit TE weist mindestens einen MOS-Feldeffekttransistor auf. Deren Drainanschlüsse sind in der Weise miteinander gekoppelt, daß ein Gesamtstrom $I_g$ die Summe aller Querströme $I_{t2}$, $I_{t3}$, ... $I_{tn}$ der in der Transistoreinheit TE enthaltenen Transistoren T1, T2, T3, ... Tn (n ist die Anzahl der Transistoren, die in der Transistoreinheit TE vorhanden sind) darstellt. Die Source-Anschlüsse der einzelnen Transistoren T1, T2, T3, ... Tn sind mit einem ersten Betriebspotential $V_{SS}$ gekoppelt. Die in der Transistoreinheit TE enthaltenen Transistoren repräsentieren in ihrer Gesamtheit einen ersten Term einer Schwellenwertgleichung, die eine Logikfunktion beschreibt. Ein zweiter Term der Schwellenwertgleichung wird durch eine Referenzeinheit RE in Form eines Referenzstroms $I_R$ gebildet.

Der bei einer Schwellenwertgleichung benötigte Vergleich zweier Eingangsgrößen, des ersten Terms der Schwellenwertgleichung und des zweiten Terms der Schwellenwertgleichung, die durch den Gesamtstrom Ig und dem Referenzstrom $I_R$ repräsentiert werden, wird durch eine Bewertungseinheit BE durchgeführt in der Weise, daß die Bewertungseinheit BE in einen stabilen Zustand kippt, der das Vergleichsergebnis der beiden zu vergleichenden Größen repräsentiert.

## Bewertungseinheit

Die Bewertungseinheit BE hat den im weiteren beschriebenen Aufbau (vgl. Figur 2). Sie besteht aus einer ersten Inverterstufe $(n_1, p_1)$ mit einem n-Kanal-MOS-Feldeffekttransistor B1 und einem p-Kanal-MOS-Feldeffekttransistor B2, durch die zum Zeitpunkt der Bewertung ein erster Bewertungsstrom $I_{B1}$ fließt, der gleich ist dem Strom, der über einen ersten Eingang E1 der Bewertungseinheit BE in die Bewertungseinheit BE fließt, in einer erfindungsgemäßen Schaltungsanordnung also dem Gesamtstrom $I_g$. Durch eine zweite Inverterstufe $(n_2; p_2)$ bestehend aus einem n-Kanal-MOS-Feldeffekttransistor B3 und einem p-Kanal-MOS-Feldeffekttransistor B4, fließt zum Zeitpunkt der Bewertung ein zweiter Bewertungsstrom $I_{B2}$, der gleich ist dem Strom, der über den zweiten Eingang E2 der Bewertungseinheit BE in die Bewertungseinheit BE fließt.

Ein Ausgang 1 der ersten Inverterstufe $(n_1, p_1)$ ist mit einem Eingang 2 der zweiten Inverterstufe $(n_2, p_2)$ verbunden. Ein Ausgang 3 der zweiten Inverterstufe $(n_2, p_2)$ ist mit einem Eingang 4 der ersten Inverterstufe $(n_1, p_1)$ verbunden. Der Eingang 4 der ersten Inverterstufe $(n_1, p_1)$ ist außerdem verbunden mit einem zweiten Anschluß 5 einer Rücksetzeinheit R. Ein erster Anschluß 6 des Rücksetztransistors R ist verbunden mit dem Eingang 2 der zweiten Inverterstufe $(n_2, p_2)$. Über ein Steuersignal $\Phi$ an dem Gate-Anschluß des Rücksetztransistors R wird die Potentialdifferenz zwischen einem ersten Ausgangspotential A und einem zweiten Ausgangspotential $\bar{A}$ der Bewertungseinheit BE bei Aktivierung des Steuersignals $\Phi$ ausgeglichen und damit die Bewertungseinheit BE in einen definierten Ausgangszustand rückgesetzt.

Zur Erklärung der Funktion der Bewertungseinheit BE wird angenommen, daß an dem Ausgang 3 der zweiten Inverterstufe ($n_2$, $p_2$) und dem Ausgang 1 der ersten Inverterstufe ($n_1$, $p_1$) zunächst gleiches Potential herrsche. Wenn der erste Bewertungsstrom $I_{B1}$ größer ist als der zweite Bewertungsstrom $I_{B2}$, so ergibt sich daraus an dem Ausgang 1 der ersten Inverterstufe ($n_1$, $p_1$) ein etwas niedrigeres Potential, als an dem Ausgang 3 der zweiten Inverterstufe ($n_2$, $p_2$).

Dadurch leitet der p-Kanal-MOS-Feldeffekttransistor B4, dessen Gate-Anschluß mit dem Ausgang 1 der ersten Inverterstufe ($n_1$, $p_1$) gekoppelt ist, besser als der p-Kanal-MOS-Feldeffekttransistor B2, und der n-Kanal-MOS-Feldeffekttransistor B3, dessen Gate-Anschluß ebenso mit dem Ausgang 1 der ersten Inverterstufe ($n_1$, $p_1$) gekoppelt ist, schlechter als der n-Kanal-MOS-Feldeffekttransistor B1, wodurch das Potential an dem Ausgang 3 der zweiten Inverterstufe ($n_2$, $p_2$) angehoben wird bis schließlich ein zweites Betriebspotential $V_{DD}$ erreicht ist. Entsprechend wird am Ausgang 1 der ersten Inverterstufe ($n_1$, $p_1$) schließlich ein Potential von 0 Volt erreicht. Damit ist ein stabiler Zustand der Bewertungseinheit BE erreicht.

Fließt zum Zeitpunkt der Bewertung durch die zweite Inverterstufe ($n_2$, $p_2$) ein zweiter Bewertungsstrom $I_{B2}$, der größer ist als der erste Bewertungsstrom $I_{B1}$, so stellt sich entsprechend dem im vorigen beschriebenen Prozeß an dem Ausgang 3 der zweiten Inverterstufe ($n_2$, $p_2$) ein Potential von 0 Volt und an dem Ausgang 1 der ersten Inverterstufe ($n_1$, $p_1$) das zweite Betriebspotential $V_{DD}$ ein.

Die Bewertungseinheit BE hat während des Bewertungsvorgangs eine sehr hohe innere Verstärkung und eine sehr gute Treiberfähigkeit und kann deshalb bei hohen Frequenzen betrieben werden.

Bevor eine neue Bewertung erfolgen kann, muß die Potentialdifferenz zwischen dem ersten Ausgangspotential A, das an dem Ausgang 1 der ersten Inverterstufe ($n_1$, $p_1$) anliegt, und dem zweiten Ausgangspotential $\bar{A}$, das an dem Ausgang 3 der zweiten Inverterstufe ($n_2$, $p_2$) anliegt, ausgeglichen werden, d.h. die Schaltungsanordnung muß zurückgesetzt werden. Dies geschieht durch die durch einen n-Kanal-MOS-Feldeffekttransistor realisierte Rücksetzeinheit R, die über ein Steuersignal $\Phi$ gesteuert wird. Es ist auch möglich, anstatt eines n-Kanal-MOS-Feldeffekttransistors einen p-Kanal-MOS-Feldeffekttransistor zu verwenden, um die Rücksetzeinheit R zu realisieren.

Der Rücksetzvorgang bei Verwendung eines n-Kanal-MOS-Feldeffekttransistors als Rücksetzeinheit R wird eingeleitet, wenn das Steuersignal $\Phi$ auf hohen Pegel geschaltet wird. Der Rücksetzvorgang bei Verwendung eines p-Kanal-MOS-Feldeffekttransistor als Rücksetzeinheit R wird eingeleitet, wenn das Steuersignal $\Phi$ auf niedrigen Pegel geschaltet wird.

Der Ladungsausgleich kann abhängig von unsymmetrischen Lasten an dem Ausgang 3 der zweiten Inverterstufe ($n_2$, $p_2$) bzw. dem Ausgang 1 der ersten Inverterstufe ($n_1$, $p_1$) zu einem Ausgleich auf hohem oder niedrigem Pegel führen. Wenn ein n-Kanal-MOS-Feldeffekttransistor zur Realisierung der Rücksetzeinheit R verwendet wird, so erfolgt auf niedrigem und mittlerem Pegel ein guter Ausgleich der beiden Ausgangspotentiale A und $\bar{A}$. Bei hohen Pegeln nahe dem zweiten Betriebspotential $V_{DD}$ ist der Ausgleich unter Umständen unvollständig. Dann leiten die MOS-Feldeffekttransistoren B2 und B4 schlecht, aber die MOS-Feldeffekttransistoren B1 und B3 gut. Dies führt zu einem schnellen Absenken des Potentials auf niedrigeres Niveau, bei dem der n-Kanal-MOS-Feldeffekttransistor zur Realisierung des Rücksetztransistors R besser leitet und den Potentialausgleich herbeiführen kann. Eine analoge Argumentation führt auch bei Verwendung eines p-Kanal-MOS-Feldeffekttransistors anstelle des n-Kanal-MOS-Feldeffekttransistors zur Realisierung des Rücksetztransistors R zu einem guten Ausgleich der Potentiale an dem Ausgang 1 der ersten Inverterstufe ($n_1$, $p_1$) und dem Ausgang 3 der zweiten Inverterstufe ($n_2$, $p_2$). Wenn das Steuersignal $\Phi$ deaktiviert wird, beginnt die neue Bewertung, die zu neuen Werten an den Ausgängen führt, d.h. die Bewertungseinheit BE wird aktiviert und kippt schnell in einen stabilen Zustand.

Aus der Tatsache, daß nur wenige, nämlich 3 Transistoren in Serie liegen zwischen dem zweiten Betriebspotential $V_{DD}$ und dem ersten Betriebspotential $V_{SS}$ ergibt sich außerdem eine hervorragende Eignung der erfindungsgemäßen Schaltungsanordnung für Anwendungen mit niedrigen Betriebsspannungen.

## Volladdiererzelle

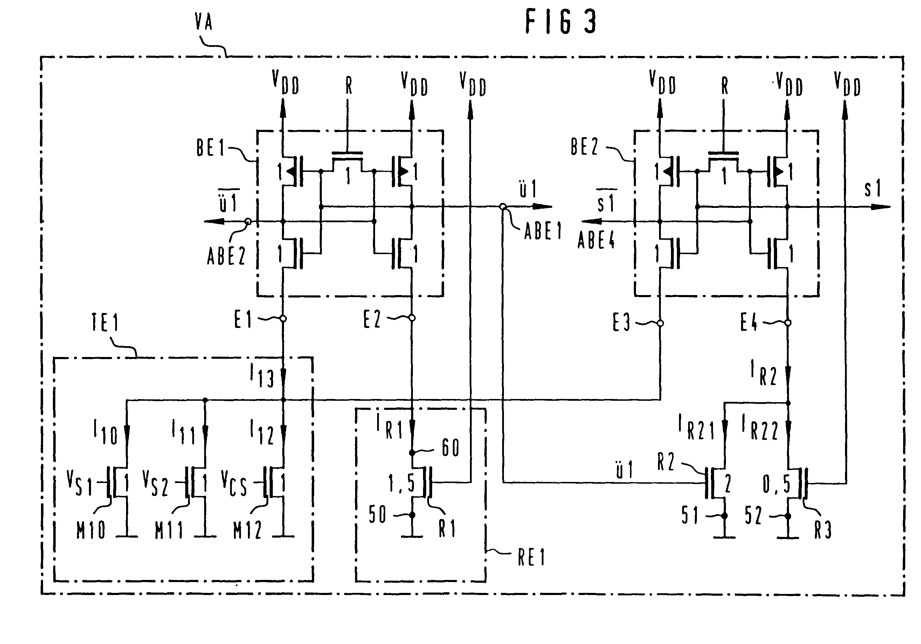

Die Funktion einer Volladdiererzelle VA kann durch zwei Schwellenwertgleichungen ausgedrückt werden. Als Eingangspotentiale liegen an der Volladdiererzelle VA ein erstes Summanden-Bit $V_{S1}$, ein zweites Summanden-Bit $V_{S2}$ und ein Übertrags-Bit einer vorangehenden Partialsumme $V_{CS}$ an. Als Ausgangssignale stellt die in Figur 3 beschriebene Volladdiererzelle VA folgende Signale zur Verfügung: Ein erstes Ausgangs-Übertrags-Bit ül, ein negiertes erstes Ausgangs-Übertrags-Bit $\bar{ü}1$, ein erstes Ausgangs-Summen-Bit s1 und ein negiertes erstes Ausgangs-Summen-Bit $\underline{s1}$ (vgl. Figur 3).

Die in Figur 3 beschriebene Volladdiererzelle VA hat folgenden Aufbau:

Eine erste Transistoreinheit TE1, die denselben prinzipiellen Aufbau hat wie die Transistoreinheit TE, ist zur Realisierung der Volladdiererzelle VA aufgebaut aus einem zehnten MOS-Feldeffekttransistor M10, einen elften MOS-Feldeffekttransistor M11, und einem zwölften MOS-Feldeffekttransistor M12.

Die Zahlenwerte direkt an den MOS-Feldeffekttransistoren geben jeweils das Kanalweiten/Kanallängen-Verhältnis des jeweiligen MOS-Feldeffekttransistors bezogen auf eine Minimalweite/Minimallänge an.

Das erste Summanden-Bit $V_{S1}$ liegt an dem zehnten MOS-Transistor M10 an und steuert einen zehnten Querstrom $I_{10}$. Ein durch den elften MOS-Transistor M11 fließender elfter Querstrom $I_{11}$ wird durch das zweite Summanden-Bit $V_{S2}$ gesteuert. Durch den vom Übertragsbit einer vorangehenden Partialsumme $V_{CS}$ gesteuerten zwölften Transistor M12 fließt ein zwölfter Querstrom $I_{12}$. Die Drainanschlüsse der MOS-Feldeffekttransistoren M10, M11 und M12 sind miteinander gekoppelt, sodaß ein erster Gesamtstrom $I_{13}$ sich ergibt aus der Summe des zehnten Querstroms $I_{10}$, des elften Querstroms $I_{11}$ und des zwölften Querstroms $I_{12}$.

Die Summe der Eingangspotentiale $V_{S1}$, $V_{S2}$, $V_{CS}$ repräsentiert einen ersten Term (S1 + S2 + CS) einer ersten Schwellenwertgleichung zur Berechnung des ersten Ausgangs-Übertrags-Bits ü1. Die Eingangspotentiale $V_{S1}$, $V_{S2}$, $V_{CS}$ repräsentieren jeweils einen Summanden entsprechend den gewählten Bezeichnungen des ersten Terms der ersten Schwellenwertgleichung. Die gesamte erste Schwellenwertgleichung zur Berechnung des ersten Ausgangs-Übertrags-Bits ü1 der Volladdiererzelle VA hat folgenden Aufbau:

$$S1 + S2 + CS > 1,5 \quad \Leftrightarrow \quad ü1 = 1$$

Ein zweiter Term der ersten Schwellenwertgleichung mit dem Wert 1,5 wird durch einen diesen Wert repräsentierenden ersten Referenzstrom $I_{R1}$, der durch einen ersten Referenztransistor R1 fließt, gebildet. Der erste Referenztransistor R1 bildet eine erste Referenzeinheit RE1, entsprechend der Referenzeinheit RE (vgl. Figur 1). Ein Gate-Anschluß des ersten Referenztransistors R1 ist mit dem zweiten Betriebspotential $V_{DD}$ verbunden. Ein Anschluß 50 des ersten Referenztransistors R1 ist mit dem Massepotential gekoppelt.

Der erste Gesamtstrom $I_{13}$ fließt zum Zeitpunkt der Bewertung über einen ersten Eingang E1 einer ersten Bewertungseinheit BE1, die denselben Aufbau hat wie die Bewertungseinheit BE, in die erste Bewertungseinheit BE1. Der erste Referenzstrom $I_{R1}$ fließt zum Zeitpunkt der Bewertung über einen zweiten Eingang E2 der ersten Bewertungseinheit BEI ebenso in die erste Bewertungseinheit BE1 , sodaß bei aktivierter erster Bewertungseinheit BEI der Vergleich des ersten Gesamtstroms $I_{13}$ mit dem ersten Referenzstrom $I_{R1}$ stattfindet.

Das erste Ausgangs-Übertrags-Bit ü1 an einem ersten Ausgang ABE1 der ersten Bewertungseinheit BE1 ist dann und nur dann logisch 1, wenn die erste Schwellenwertgleichung erfüllt ist. In diesem Fall ist das negierte erste Ausgangs-Übertrags-Bit $\overline{ü1}$, das an einem zweiten Ausgang ABE2 der ersten Bewertungseinheit BEI anliegt, logisch 0.

Ist die erste Schwellenwertgleichung nicht erfüllt, so ist das erste Ausgangs-Übertrags-Bit ü1 logisch 0 und das negierte erste Ausgangs-Übertrags-Bit $\overline{ü1}$ logisch 1.

Da die erste Bewertungseinheit BE1 stromlos wird, wenn sie in einen stabilen Zustand gekippt ist, kann eine zweite Bewertungseinheit BE2, ebenso gleichen Aufbaus wie die Bewertungseinheit BE, zur Berechnung des ersten Ausgangs-Summen-Bits s1 und des negierten ersten Ausgangs-Summen-Bits $\overline{s1}$ mit der ersten Transistoreinheit TE1, die mit dem ersten Eingang E3 der zweiten Bewertungseinheit BE2 gekoppelt ist, betrieben werden, mit der die erste Bewertungseinheit BEI an dem ersten Eingang E1 der ersten Bewertungseinheit BEI beschaltet ist. Dazu ist es nötig, die erste Bewertungseinheit BEI und die zweite Bewertungseinheit BE2 so zu steuern, daß eine Rücksetzeinheit der zweiten Bewertungseinheit BE2 die zweite Bewertungseinheit BE2 erst dann zurücksetzt und anschließend aktiviert, wenn die erste Bewertungseinheit BEI in einen stabilen Zustand gekippt ist, also das erste Ausgangs-Übertrags-Bit ü1 stabil anliegt, d. h. es dürfen zu keinem Zeitpunkt die erste Bewertungseinheit BEI und die zweite Bewertungseinheit BE2 gleichzeitig aktiv sein. Dies stellt allerdings keine Einschränkung der Volladdiererzelle dar, da zur Bewertung der zweiten Schwellenwertgleichung das erste Ausgangs-Übertrags-Bit ü1 ohnehin stabil anliegen muß. Dies ist notwendig, da es direkt in die zweite Schwellenwertgleichung eingeht.

Dies ermöglicht eine erhebliche Verringerung der Anzahl benötigter Transistoren womit natürlich auch die benötigte Chipfläche für den jeweiligen Grundbaustein reduziert wird, da die erste Transistoreinheit TE1 nur einmal für die erste Bewertungseinheit BE1 und die zweite Bewertungseinheit BE2 verwendet wird.

Wenn die erste Bewertungseiheit BEI in einen stabilen Zustand gekippt ist, fließt der erste Gesamtstrom $I_{13}$ zum Zeitpunkt der Bewertung in der zweiten Bewertungseinheit BE2 über den ersten Eingang E3 der zweiten Bewertungseinheit BE2 durch die zweite Bewertungseinheit BE2 zur Bildung des ersten Ausgangs-Summen-Bits s1.

Die Summe der Eingangspotentiale $V_{S1}$, $V_{S2}$, $V_{CS}$ repräsentiert in diesem Zusammenhang einen ersten Term (S1 + S2 + CS) einer zweiten Schwellenwertgleichung zur Berechnung des ersten Ausgangs-Summen-Bits sl. Die Eingangspotentiale $V_{S1}$, $V_{S2}$, $V_{CS}$ repräsentieren jeweils einen Summanden entsprechend den gewählten Bezeichnungen des ersten Terms der zweiten Schwellenwertgleichung. Die gesamte zweite Schwellenwertgleichung zur Berechnung des ersten Ausgangs-Summen-Bits s1 der Volladdiererzelle VA hat folgenden Aufbau:

$$S1 + S2 + CS > 0,5 + 2 * ü1 \qquad \Leftrightarrow \qquad s1 = 1$$

Ein zweiter Term der zweiten Schwellenwertgleichung mit dem Wert (0,5 + 2*ü) wird durch einen diesen Wert repräsentierenden zweiten Referenzstrom $I_{R2}$ gebildet. Das bedeutet, daß der zweite Referenzstrom $I_{R2}$ für die zweite Bewertungseinheit BE2 keine feste Größe ist, sondern vom Ergebnis der Bewertung der ersten Bewertungseinheit BE1 abhängt. In diesem Zusammenhang, also zur Bildung des ersten Ausgangs-Summen-Bits sl, weist die Referenzeinheit RE aus Figur 1 in Figur 3 einen zweiten Referenztransistor R2 und einen dritten Referenztransistor R3 auf, wobei ein durch den zweiten Referenztransistor R2 fließender Querstrom $I_{R22}$ den zweifachen Wert des ersten Ausgangs-Übertrags-Bits ü1, also 2*ü1 repräsentiert. Ein Querstrom $I_{R21}$, der durch den dritten Referenztransistor R3 fließt, repräsentiert den Wert 0,5. Damit repräsentiert der zweite Referenzstrom $I_{R2}$ den zweiten Term der zweiten Schwellenwertgleichung (0,5 + 2 * ü1).

Die Drain-Anschlüsse des zweiten Referenztransistors R2 und des dritten Referenztransistors R3 und ein zweiter Eingang E4 der zweiten Bewertungeinheit BE2 sind verbunden. Ein Gate-Anschluß des zweiten Referenztransistors R2 ist mit dem ersten Ausgang der ersten Bewertungseinheit BE1 verbunden. Durch die Dimensionierung des zweiten Referenztransistors R2 erfährt das erste Ausgangs-Übertrags-Bit ül die notwendige Gewichtung mit dem Faktor, 2. Ein Anschluß 51 des zweiten Referenztransistors R2 ist ebenso mit dem Massepotential gekoppelt wie ein Anschluß 52 des dritten Referenztransistors R3.

Der Gate-Anschluß des dritten Referenztransistors R3 ist mit dem zweiten Betriebspotential $V_{DD}$ verbunden.

Der erste Gesamtstrom $I_{13}$ fließt zum Zeitpunkt der Bewertung innerhalb der zweiten Bewertungseinheit BE2 über einen ersten Eingang E3 der zweiten Bewertungseinheit BE2 in die zweite Bewertungseinheit BE2. Der zweite Referenzstrom $I_{R2}$ fließt zum Zeitpunkt der Bewertung innerhalb der zweiten Bewertungseinheit BE2 über einen zweiten Eingang E4 der zweiten Bewertungseinheit BE2 ebenso in die zweite Bewertungseinheit BE2, sodaß bei aktivierter zweiter Bewertungseinheit BE2 der Vergleich des ersten Gesamtstroms $I_{13}$ mit dem zweiten Referenzstrom $I_{R1}$ stattfindet.

Das erste Ausgangs-Summen-Bit s1 an einem ersten Ausgang ABE3 der zweiten Bewertungseinheit BE2 ist dann und nur dann logisch 1, wenn die zweite Schwellenwertgleichung erfüllt ist. In diesem Fall ist das negierte erste Ausgangs-Summen-Bit $\overline{s1}$ logisch 0.

Ist die zweite Schwellenwertgleichung nicht erfüllt, so ist das erste Ausgangs-Summen-Bit s1 logisch 0 und das negierte erste Ausgangs-Summen-Bit $\overline{s1}$ logisch 1.

Wenn das erste Summanden-Bit $V_{S1}$, das zweite Summanden-Bit $V_{S2}$ und das Übertrags-Bit einer vorangehenden Partialsumme $V_{CS}$ gleichzeitig nach einer Bewertung mit dem Ergebnis $\overline{ü1}$ = 0 an dem zweiten Ausgang ABE2 der ersten Bewertungseinheit BEI und/oder mit dem Ergebnis $\overline{s1}$ =0 an einem zweiten Ausgang ABE4 der zweiten Bewertungseinheit BE2 auf ein Potential mit dem Wert 0 schalten, so kann der Fall auftreten, daß der zweite Ausgang ABE2 der ersten Bewertungseinheit BE1, der erste Eingang E1 der ersten Bewertungseinheit BE1, der zweite Ausgang ABE4 der zweiten Bewertungseinheit BE2 und der erste Eingang E3 der zweiten Bewertungseinheit BE2 zu schwebenden Knoten, d.h. floatend, werden.

Da der zweite Ausgang ABE2 der ersten Bewertungseinheit BE1 und der zweite Ausgang ABE4 der zweiten Bewertungseinheit BE2 in der Volladdiererzelle VA zur Realisierung der Volladdiererzelle VA nicht weiter verwendet werden, wirkt sich dieser Fall aber nicht auf die Funktionsweise der Volladdiererzelle VA aus. Sofern aber Probleme z. B. durch kapazitive Einkopplungen an diesen Knoten, die zu einer Änderung der Bewertungsergebnisse führen könnten, nicht ausgeschlossen werden können, kann dieser Situation dadurch Abhilfe geschaffen werden, indem die erste Transistoreinheit TE1 um einen ersten Zusatztransitor L1 erweitert wird, über den in jedem Fall eine niederohmige Verbindung des ersten Eingangs E1 der ersten Bewertungseinheit BE1 und des ersten Eingangs E3 der zweiten Bewertungseinheit BE2 zum Massepotential geschaffen wird und somit die Ladungen des schwebenden Knotens abfließen können. Der erste Zusatztransitor L1 kann z.B. ein auf das Minimalweiten/Minimallängen-Verhältnis bezogenes Kanalweiten/Kanallängen-Verhältnis mit dem Wert 1 aufweisen. Ein Drain-Anschluß des ersten Zusatztransitors Ll ist mit den Drain-Anschlüssen der anderen in der ersten Transistoreinheit TE1 enthaltenen Transistoren verbunden. Der Gate-Anschluß des ersten Zusatztransitors L1 ist gekoppelt mit dem zweiten Betriebspotential $V_{DD}$.

Durch die im vorigen beschrieben Maßnahme wird der erste Gesamtstrom $I_{13}$ zum Zeitpunkt der Bewertung in der ersten Bewertungseinheit BEI bzw. ein zweiter Gesamtstrom $I_{14}$ zum Zeitpunkt der Bewertung in der zweiten Bewertungseinheit BE2 erhöht. Damit die Bewertung trotzdem weiter das richtige Vergleichsergebnis ergibt, müssen in diesem Fall auch der erste Referenzstrom $I_{R1}$ und der zweite Referenzstrom $I_{R2}$ in demselben Maß erhöht werden. Dies kann z.B. erreicht werden durch eine Änderung der Dimensionierung des ersten Referenztransistors R1 und des dritten Referenztransistors R3 in der entsprechenden Weise.

**Multipliziererzelle**

Die Funktion einer Multipliziererzelle MUL kann ebenfalls durch zwei Schwellenwertgleichungen ausgedrückt werden. Als Eingangspotentiale liegen an der Multipliziererzelle MUL ein Multiplikator-Bit $V_{a1}$, ein

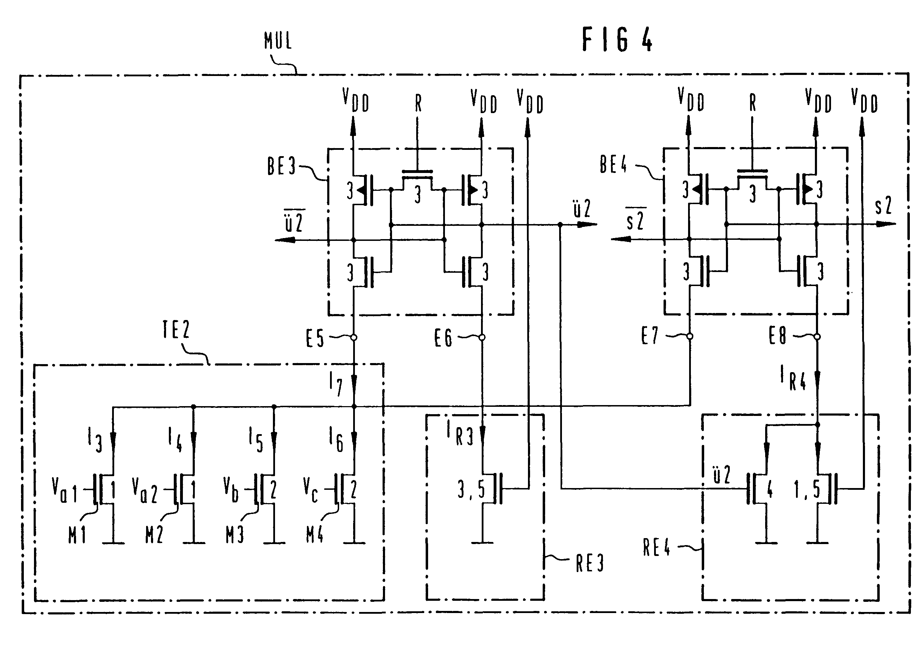

Multiplikanden-Bit $V_{a2}$ ein Summen-Bit einer vorangehenden Partialsumme $V_b$ und ein Übertrags-Bit einer vorangehenden Partialsumme $V_C$ an. Als Ausgangssignale stellt die in Figur 4 beschriebene Multipliziererzelle MUL folgende Signale zur Verfügung. Ein zweites Ausgangs-Übertrags-Bit ü2, ein negiertes zweites Ausgangs-Übertrags-Bit $\overline{ü2}$, ein zweites Ausgangs-Summen-Bit s2 und ein negiertes zweites Ausgangs-Summen-Bit $\overline{s2}$ (vgl. Figur 4).

Die in Figur 4 beschriebene Multipliziererzelle MUL hat den prinzipiell gleichen Aufbau wie die im vorigen beschriebene Volladdiererzell VA (vgl. Figur 3). Die zwei Schwellenwertgleichungen der Multipliziererzelle MUL haben jedoch einen anderen Aufbau.

Eine dritte Schwellenwertgleichung, die zur Berechnung des zweiten Ausgangs-Übertrags-Bits ü2 sowie des negierten zweiten Ausgangs-Übertrags-Bits $\overline{ü2}$ vorgesehen ist, hat folgenden Aufbau:

$$(a_1 + a_2) + 2 * b + 2 * c > 3,5.$$

Das zweite Ausgangs-Übertrags-Bits ü2 ist dann und nur dann logisch 1, wenn die dritte Schwellenwertgleichung eine wahre Aussage liefert.

Eine vierte Schwellenwertgleichung, die zur Berechnung des zweiten Ausgangs-Summen-Bits s2 sowie des negierten zweiten Ausgangs-Summen-Bits $\overline{s2}$ vorgesehen ist, hat folgenden Aufbau:

$$(a_1 + a_2) + 2 * b + 2 * c > 1,5 + 4 * ü.$$

Das zweite Ausgangs-Summen-Bit s2 ist dann und nur dann logisch 1, wenn die vierte Schwellenwertgleichung eine wahre Aussage liefert.

In den zwei obigen Formeln sind jeweils die Bezeichnungen der Variablen entsprechend den Bezeichnungen der Eingangspotentiale der Multipliziererzelle MUL gewählt.

Um die dritte Schwellenwertgleichung und die vierte Schwellenwertgleichung zu realisieren, ist es nötig, eine zweite Transistoreinheit TE2, eine dritte Referenzeinheit RE3 und eine vierte Referenzeinheit RE4 im Vergleich zur Volladdiererzelle VA, so umzugestalten, daß die die dritte Schwellenwertgleichung und die vierte Schwellenwertgleichung repräsentiert werden. Dazu ist es z.B. notwendig, einen weiteren Transistor in die zweite Transistoreinheit TE2 hinzuzufügen, damit die bei der Multipliziererzelle MUL benötigten vier Eingangspotentiale angelegt werden können. Auch die Dimensionierungen der Transitoren der zweiten Transistoreinheit TE2 müssen der dritten Schwellenwertgleichung und der vierten Schwellenwertgleichung angepaßt werden, z.B. durch Änderung der auf das Minimalweiten/Minimallängen-Verhältnis bezogenen Kanalweiten/Kanallängen-Verhältnisse der einzelnen Transistoren der zweiten Transistoreinheit TE2.

Somit weist die zweite Transistoreinheit TE2 die folgenden MOS-Feldeffekttransistoren auf:

- M1, durch den zum Zeitpunkt der Aktivierung der Bewertungseinheiten ein dritter Querstrom $I_3$ fließt, der in seinem Wert das Multiplikator-Bit $V_{a1}$ repräsentiert,
- M2, durch den zum Zeitpunkt der Aktivierung der Bewertungseinheiten ein vierter Querstrom $I_4$ fließt, der in seinem Wert das Multiplikanden-Bit $V_{a2}$ repräsentiert,
- M3, durch den zum Zeitpunkt der Aktivierung der Bewertungseinheiten ein fünfter Querstrom $I_5$ fließt, der in seinem Wert das Summen-Bit einer vorangehenden Partialsumme $V_b$ multipliziert mit einem Faktor 2 repräsentiert und
- M4, durch den zum Zeitpunkt der Aktivierung der Bewertungseinheiten ein sechster Querstrom $I_6$ fließt, der in seinem Wert das Übertrags-Bit einer vorangehenden Partialsumme $V_C$ multipliziert mit einem Faktor 2 repräsentiert.

Die Querströme $I_3$, $I_4$, $I_5$ und $I_6$ bilden zusammen einen zweiten Gesamtstrom $I_7$, der über einen ersten Eingang E5 einer dritten Bewertungseinheit BE3 bei der Aktivierung in die dritte Bewertungseinheit BE3 fließt, die zur Bildung des zweiten Ausgangs-Übertrags-Bit ü2 vorgesehen ist. Wenn das zweite Ausgangs-Übertrags-Bit ü2 stabil anliegt, sollte eine vierte Bewertungseinheit BE4 zurückgesetzt und wieder aktiviert werden, die zur Bildung des zweiten Ausgangs-Summen-Bits s2 vorgesehen ist. Zu diesem Zeitpunkt ist die dritte Bewertungseinheit BE3 stromlos und somit fließt der zweite Gesamtstrom $I_7$ über einen ersten Eingang E5 der vierten Bewertungseinheit BE4 in die vierte Bewertungseinheit BE4.

Ein dritter Referenzstrom $I_{R3}$ sowie ein vierter Referenzstrom $I_{R4}$ werden gebildet durch eine dritte Referenzeinheit RE3 und eine vierte Referenzeinheit RE4, die denselben prinzipiellen Aufbau haben wie die Referenzeinheit RE. Nur die Dimensionierung der Transistoren, die jeweils die dritte Referenzeinheit RE3 und die vierte Referenzeinheit RE4 bilden, wird so angepaßt, daß der dritte Referenzstrom $I_{R3}$ und der vierte Referenzstrom $I_{R4}$ jeweils einen zweiten Term der dritten Schwellenwertgleichung und einen zweiten Term der vierten Schwellenwertgleichung repräsentieren.

Jede Funktionsgleichung, und damit jedes Logikelement, das durch mindestens eine Schwellenwertgleichung dargestellt werden kann, kann nach den im vorigen beschriebenen Prinzip realisiert werden.

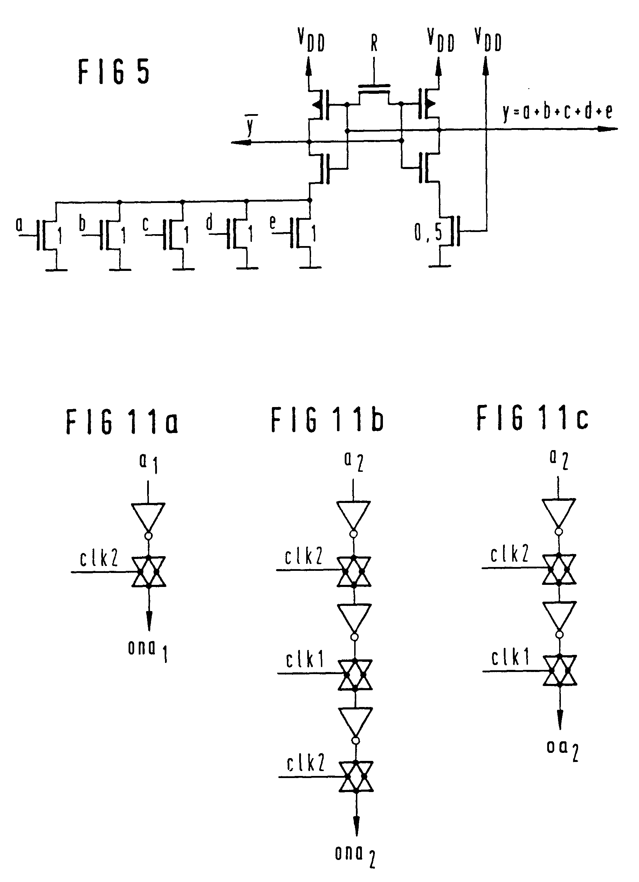

Figur 5 zeigt beispielsweise eine erfindungsgemäße Schaltungsanordnung zur Realisierung eines Fünffach-ODER-Gatters.

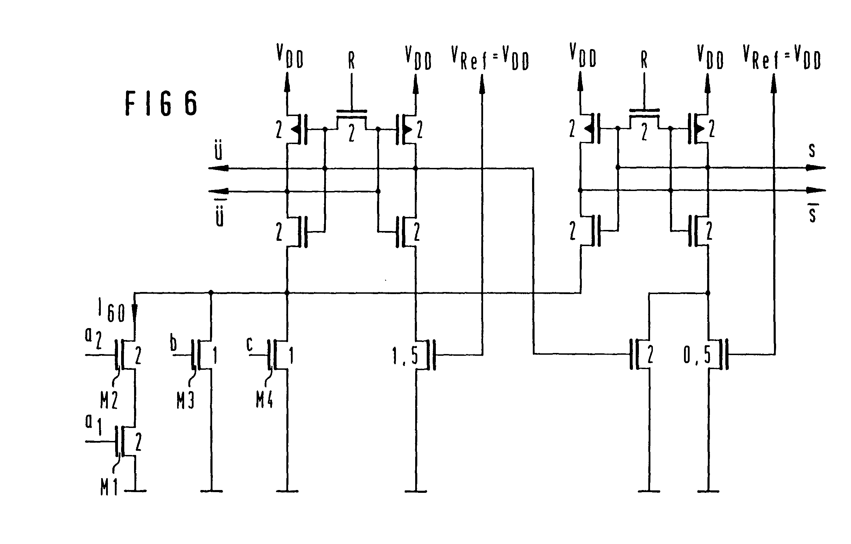

Eine vorteilhafte Weiterbildung der erfindungsgemäßen Schaltungsanordnung zur Realisierung einer binären Multipliziererzelle ist in Figur 6 dargestellt.

Die Transistoren Ml und M2 sind in der in Figur 6 beschriebenen erfindungsgemäßen Schaltungsanordnung nicht parallel geschaltet, sondern in Reihe, so daß sie in einem Strompfad liegen. Durch diesen Strompfad fließt ein UND-Querstrom $I_{60}$. Der UND-Querstrom $I_{60}$ fließt nur dann, wenn sowohl das Multiplikator-Bit $V_{al}$ als auch das Multiplikanden-Bit $V_{a2}$ logisch 1 sind. Dies entspricht der Realisierung der in einer binären Multipliziererzelle benötigten UND-Verknüpfung. Die Dimensionierung der MOS-Feldeffekttransistoren M1, M2, M3 und M4 muß so ausgelegt sein, daß die durch die MOS-Feldeffekttransistoren M1, M2, M3 und M4 fließenden Querströme den ersten Term der ersten Schwellenwertgleichung repräsentieren.

Dies kann z.B. dadurch erreicht werden, daß das Kanalweiten/Kanallängen-Verhältnis der MOS-Feldeffekttransistoren M1 und M2 bezogen auf eine Minimalweite/Minimallänge den Wert 2 hat, und das Kanalweiten/Kanallängen-Verhältnis bezogen auf eine Minimalweite/Minimallänge den Wert der MOS-Feldeffekttransistoren M3 und M4 den Wert 1 zugeordnet bekommen.

Entsprechend muß auch das Kanalweiten/Kanallängen-Verhältnis des MOS-Feldeffekttransistors der dritten Referenzeinheit RE3 auf den Wert 1,5 dimensioniert werden. Die Dimensionierungen der weiteren MOS-Feldeffekttransistoren sind in Figur 6 angegeben, wobei die Zahlenwerte direkt an den MOS-Feldeffekttransistoren jeweils das Kanalweiten/Kanallängen-Verhältnis des jeweiligen MOS-Feldeffekttransistors bezogen auf eine Minimalweite/Minimallänge angeben.

Ein Vorteil der Weiterbildung der in Figur 6 beschriebenen erfindungsgemäßen Schaltungsanordnung besteht darin, daß der zweite Gesamtstrom $I_7$ um den Faktor 2 verringert wurde, sodaß die MOS-Feldeffekttransistoren der erfindungsgemäßen Schaltungsanordnung kleiner dimensioniert werden können (vgl. Figur 6).

Somit ergibt sich bei dieser Dimensionierung eine Verringerung des Platzbedarfs und eine Reduktion der Verlustleistung der Multipliziererzelle.

Außerdem sind die zu detektierenden relativen minimalen Stromdifferenzen um den Faktor 2 größer geworden, was die Schwellenwertbedingung entschärft.

Für den Einsatz der im vorigen beschriebenen Multipliziererzelle in Feldmultiplizierern mit Pipelining ist nun folgendes zu beachten: Das zweite Ausgangs-Übertrags-Bit ü2 wird stabil, nachdem die Rücksetzeinheit R der dritten Bewertungseinheit BE3 aus dem leitenden Zustand wieder in den sperrenden Zustand versetzt wird. Die Rücksetzeinheit R der vierten Bewertungseinheit BE4 darf erst dann aus dem leitenden Zustand wieder in den sperrenden Zustand versetzt werden, wenn das zweite Ausgangs-Übertrags-Bit ü2 stabil ist. Für die gesamte Dauer der Berechnung müssen außerdem alle Eingangssignale stabil anliegen. Es bietet sich also an, die Eingangssignale mit einem Taktsignal clk1 an die Gateanschlüsse der MOS-Feldeffekttransistoren der zweiten Transistoreinheit TE2 anzulegen.

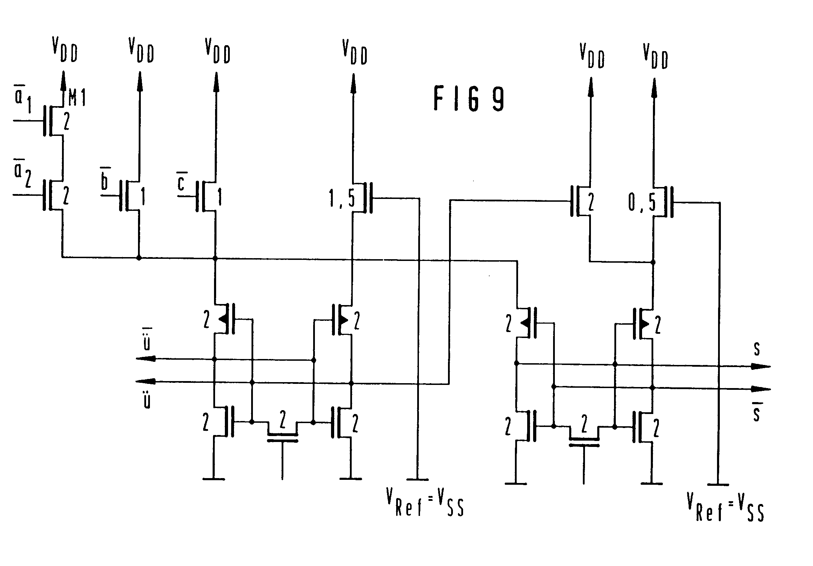

Ebenso sollte das Taktsignal clkl auch an die Rücksetzeinheit R der dritten Bewertungseinheit BE3 angelegt sein. Bei den Eingangssignalen ist zu beachten, daß diese den vollen Spannungshub haben müssen, da der Vergleich mit einer Referenzspannung erfolgt. Daher sollten Transfergatter für das Anlegen der Eingangssignale verwendet werden. Beim Anlegen der Eingangssignale über einzelne Transfertransistoren wird der Spannungshub um ein Einsatzpotential vermindert. Das zweite Ausgangs-Übertrags-Bit ü2 und das zweite Ausgangs-Summen-Bit s2 können instabil werden, wenn bei der binären Multipliziererzelle für nichtinvertierte Eingangssignale alle Eingangssignale auf 0 Volt liegen und das invertierte Ausgangssignal der zuletzt durchgeführten Bewertung auf 0 Volt war oder wenn bei einer binären Multipliziererzelle für invertierte Eingangssignale (vgl. Figur 9) alle Eingangssignale auf dem zweiten Betriebspotential $V_{DD}$ liegen und das invertierte Ausgangssignal der zuletzt vorher durchgeführten Bewertung auf dem zweiten Betriebspotential $V_{DD}$ war. Davon sind bei der Multipliziererzelle für nicht invertierte Eingangssignale vor allem die invertierten Ausgänge und bei der Zelle für invertierte Eingangssignale vor allem die nicht invertierten Ausgänge betroffen. Die Ausgangssignale sollten also nach Möglichkeit abgetastet werden, bevor die Eingangssignale wechseln.

Der Einsatz der vorgestellten Zelle in Feldmultiplizierern mit Pipelining ist einfach, wenn drei nicht überlappende Taktsignale clk1, clk2, clk3 zur Verfügung stehen. Das erste Taktsignal clk1 kann das Anlegen der Eingangssignale und den Rücksetzvorgang für die Bildung des zweiten Ausgangs-Übertrags-Bits ü2 bewirken, ein zweites Taktsignal clk2 setzt die vierte Bewertungseinheit BE4 für die Bildung des zweiten Ausgangs-Summen-Bits s2 zurück und ein drittes Taktsignal clk3 sorgt für die Auskopplung der Ausgangssignale und damit für das Anlegen der Eingangssignale an die nächste Multipliziererzelle. Üblicherweise stehen in heutigen Schaltungen mit Pipelining aber nur zwei nicht überlappende Takte clk1 und clk2 und eventuell die dazu inversen Takte nclk1 und nclk2 zur Verfügung. Unter diesen Umständen kann folgende Lösungsmöglichkeit verwendet werden.

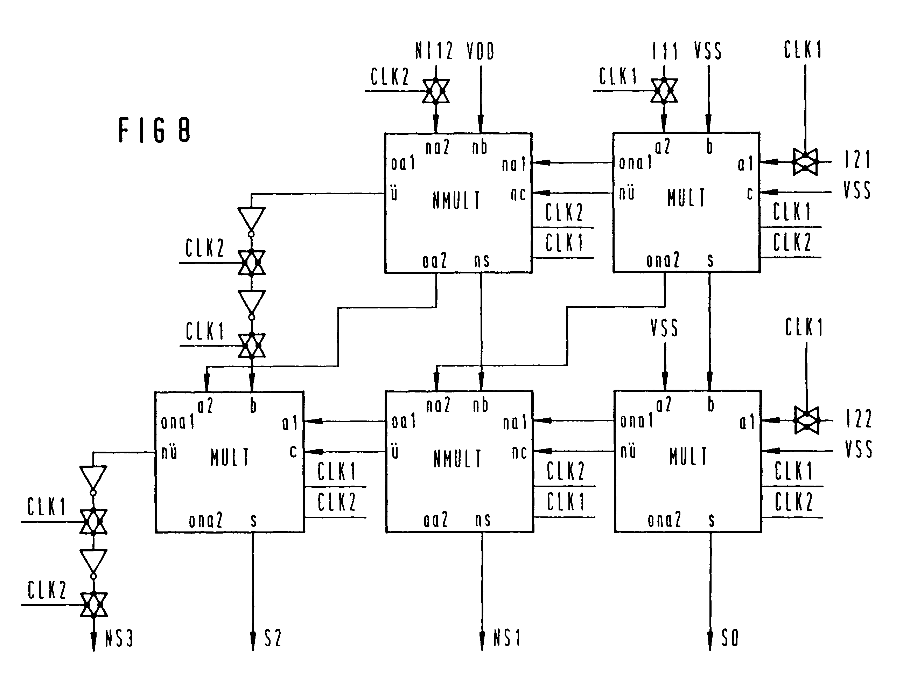

Wenn die Eingangssignale mit dem Taktsignal clk1 und die Rücksetzeinheit R der dritten Bewertungseinheit B3 ebenso mit dem ersten Taktsignal clkl angesteuert werden, so kann das zweite Ausgangsübertragsbit bereits mit dem zweiten Taktsignal clk2 an eine andere Zelle angelegt werden. Daher eignet sich diese Zelle besonders für schnelle Feldmultiplizierer mit Carry-Ripple-Addition der Partialprodukte. Da die Eingangssignale während der aktiven Phase des zweiten Taktsignals clk2 noch stabil sind, kann sowohl das zweite Ausgangs-Übertrags-Bit ü2 als auch das negierte zweite Ausgangs-Übertrags-Bit $\overline{ü2}$ sicher ausgekoppelt werden. Das Multiplikator-Bit $V_{a1}$·muß in einer solchen, in Figur 8 beschriebenen Carry-Ripple-Architektur durch ein Latch verzögert werden. Da invertierende Latches einfacher zu realisieren sind als nicht invertierende, bietet es sich an, das negierte zweite Ausgangs-Übertrags-Bit $\overline{\overline{ü2}}$ auszukoppeln. Aus diesen Überlegungen ergeben sich auch Anforderungen an das Verzögern des Multiplikanden-Bits $V_{a2}$. Das Multiplikanden-Bit $V_{a2}$ muß mit drei Latches verzögert werden und kann ebenfalls invertiert genutzt werden (vgl. Figur 8).

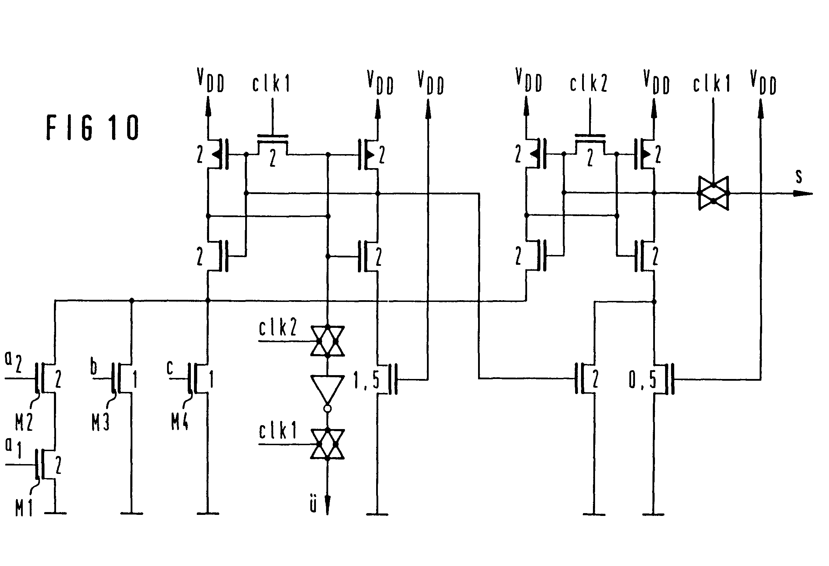

In Figur 10 ist eine erfindungsgemäße Schaltungsanordnung einer Multipliziererzelle mit Carry-Save-Addition der Partialprodukte dargestellt. Auch diese Multipliziererzelle kann vorteilhaft in einem Feldmultiplizierer mit Pipelining eingesetzt werden.

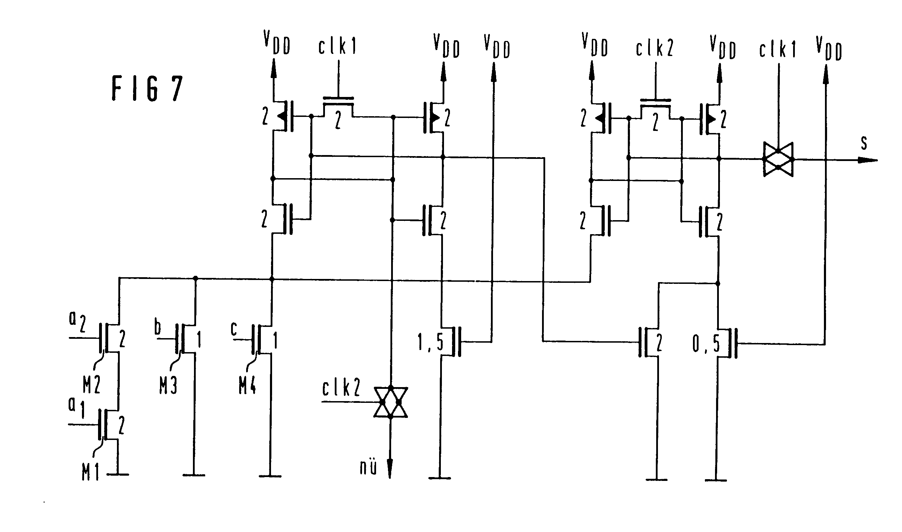

Die in Figur 8 mit MULT bezeichneten Schaltungsblöcke repräsentieren jeweils die in Figur 7 dargestellte Multipliziererzelle für nicht invertierte Eingangssignale.

Die mit NMULT bezeichneten Schaltungsblöcke repräsentieren eine Multipliziererzelle für invertierte Eingangssignale die man erhält durch Vertauschen der n-Kanal-MOS-Feldeffekttransistoren mit p-Kanal-MOS-Feldeffekttransistoren und durch Vertauschen der p-Kanal-MOS-Feldeffekttransistoren mit n-Kanal-MOS-Feldeffekttransistoren bis auf die Transistoren, die als Rücksetzeinheiten verwendet werden.

Hierbei bilden ein erstes Least-Significant-Bit I11 und ein erstes Daten-Bit NI12 ein erstes Datenwort und ein zweites Least-Significant-Bit I21 und ein zweites Daten-Bit I22 ein zweites Datenwort. Durch den dargestellten Feldmultiplizierer wird das erste Datenwort mit dem zweiten Datenwort multipliziert. Das Ergebnis der Multiplikation wird durch ErgebnisBits NS3, S2, S1, und S0 repräsentiert, wobei das Symbol N in diesem Zusammenhang das entsprechende Bit in negierter Form beschreibt. So bezeichnet also NS3 das invertierte Ergebnis-Bit S3.

Das dargestellte Prinzip des Feldmultiplizierers ist für jeden Fachmann leicht auf jede beliebige Datenwortbreite erweiterbar.

Ein Symbol o, das zu Beginn einer Signalbezeichnung geschrieben ist, bezeichnet ein Ausgangssignal des jeweiligen Schaltungsblocks MULT oder NMULT. So bezeichnet z. B. oal ein das Multiplikator-Bit al repräsentierendes Ausgangssignal eines Schaltungsblocks.

Ein Symbol n, das zu Beginn einer Signalbezeichnung geschrieben ist, bezeichnet das entsprechende Signal in negierter Form. So bezeichnet z. B. onal ein das negierte Multiplikator-Bit al repräsentierendes negiertes Ausgangssignal eines Schaltungsblocks.

Wie in Figur 11a dargestellt ist, ist das Multiplikator-Bit al außerdem durch ein Latch entsprechend Figur 7 verzögert.

Auch das Signal ona2 ergibt sich durch mehrfache Verzögerung durch mehrere Latches aus dem Multiplikanden-Bit a2 (vgl. Figur 11b).

Das Signal oa2 ergibt sich in der in Figur llc dargestellten Weise.

Zu beachten ist, daß negierte Ausgänge eines Schaltungsblocks mit negierten Eingängen eines weiteren Schaltungsblocks gekoppelt sind.

Nicht-negierte Ausgänge eines Schaltungsblocks sind ebenso mit nicht-negierten Eingängen eines weiteren Schaltungsblocks gekoppelt.

**Patentansprüche**

1. Schaltungsanordnung zur Realisierung von Logikelementen,

- bei der eine Transistoreinheit (TE) mit mindestens einem Transistor (T1, T2, T3, ... Tn) vorgesehen ist, wobei die Transistoren (T1, T2, T3, ... Tn) so dimensioniert sind, daß durch die Transistoren (T1, T2, T3, ... Tn) fließende Querströme ($I_{t1}$, $I_{t2}$, $I_{t3}$, ..., $I_{tn}$) jeweils einen Summanden eines ersten Terms einer Schwellenwertgleichung darstellen,
- bei der eine Referenzeinheit (RE) vorgesehen ist, die einen zweiten Term der Schwellenwertgleichung zur Verfügung stellt,
- bei der eine Bewertungseinheit (BE) vorgesehen ist zum Vergleichen des ersten Terms mit dem zweiten Term,
- bei der alle Transistoren der Transistoreinheit (TE) parallel geschaltet sind und über einen Ausgang (ATE) der Transistoreinheit (TE) mit einem ersten Eingang (E1) der Bewertungseinheit (BE) verbunden sind,
- bei der ein Ausgang der Referenzeinheit (ARE) mit einem zweiten Eingang (E2) der Bewertungseinheit (BE) verbunden ist, dadurch gekennzeichnet daß
- die Bewertungseinheit (BE) eine Schaltungsanordnung zum Vergleich zweier elektrischer Größen umfaßt, wobei

-- eine erste aus MOS Feldeffekttransistoren aufgebaure Inverterstufe ($n_1$, $p_1$) vorgesehen ist, durch die ein erster Querstrom ($I_1$) fließt, dessen Wert den Wert des ersten Terms repräsentiert,
-- der erste Eingang (E1) der Bewertungseinheit (BE) ein Source-Anschluß der ersten Inverterstufe ($n_1$, $p_1$) ist,
-- eine zweite aus MOS Feldeffekttransistoren aufgebaure Inverterstufe ($n_2$, $p_2$) vorgesehen ist, durch die ein zweiter Querstrom ($I_2$) fließt, dessen Wert den Wert des zweiten Terms repräsentiert,
-- der zweite Eingang (E2) der Bewertungseinheit (BE) ein Source-Anschluß der zweiten Inverterstufe ($n_2$, $p_2$) ist,
-- die erste Inverterstufe ($n_1$, $p_1$) und die zweite Inverterstufe ($n_2$, $p_2$) mitgekoppelt sind, wobei ein Ausgang (50) der ersten In-

verterstufe ($n_1$, $p_1$) mit einem Eingang (52) der zweiten Inverterstufe ($n_2$, $p_2$) verbunden ist und wobei ein Ausgang (51) der zweiten Inverterstufe ($n_2$, $p_2$) mit einem Eingang (53) der ersten Inverterstufe ($n_1$, $p_1$) verbunden ist,

-- eine Rücksetzeinheit (5) zum Ausgleich einer Potentialdifferenz zwischen einem Ausgangspotential (A) der ersten Inverterstufe ($n_1$, $p_1$) und einem Ausgangspotential ($A$) der zweiten Inverterstufe ($n_2$, $p_2$) vorgesehen ist, und

-- das Ausgangspotential (A) der ersten Inverterstufe ($n_1$, $p_1$) ein Vergleichsergebnis des ersten Querstroms ($I_1$) mit dem zweiten Querstrom ($I_2$) beschreibt.

2. Schaltungsanordnung nach Anspruch 1, bei der die Referenzeinheit (RE) mindestens einen Referenztransistor aufweist, der mit einem Anschluß (60) an den zweiten Eingang (E2) der Bewertungseinheit (BE) gekoppelt ist.

3. Schaltungsanordnung nach Anspruch 1 oder 2, bei der die Transistoreinheit (TE) für mehrere Vergleiche durch mehrere Bewertungseinheiten vorgesehen ist.

4. Binäre Volladdiererzelle mit einer Schaltungsanordnung nach einem der Ansprüche 1 bis 3.

5. Binäre Multipliziererzelle mit einer Schaltungsanordnung nach einem der Ansprüche 1 bis 3.

6. Feldmultiplizierer mit mehreren Multipliziererzellen nach Anspruch 5.


**Claims**

1. Circuit arrangement for producing logic elements,

- in which a transistor unit (TE) having at least one transistor (T1, T2, T3, ... Tn) is provided, the transistors (T1, T2, T3, ... Tn) being dimensioned such that parallel-path currents ($I_{t1}$, $I_{t2}$, $I_{t3}$, ..., $I_{tn}$) flowing through the transistors (T1, T2, T3, ... Tn) each represent a summand of a first term in a threshold value equation,
- in which a reference unit (RE) is provided which supplies a second term for the threshold value equation,
- in which a rating unit (BE) is provided for comparing the first term with the second term,
- in which all the transistors in the transistor unit (TE) are connected in parallel and are connected to a first input (E1) of the rating unit (BE) via an output (ATE) of the transistor unit (TE),

- in which an output of the reference unit (ARE) is connected to a second input (E2) of the rating unit (BE),

characterized in that

- the rating unit (BE) comprises a circuit arrangement for comparing two electrical variables, where

-- a first inverter stage ($n_1$, $p_1$) constructed from MOS field-effect transistors is provided and has a first parallel-path current ($I_1$) flowing through it, whose value represents the value of the first term,

-- the first input (E1) of the rating unit (BE) is a source connection of the first inverter stage ($n_1$, $p_1$),

-- a second inverter stage ($n_2$, $p_2$) constructed from MOS field-effect transistors is provided and has a second parallel-path current ($I_2$) flowing through it, whose value represents the value of the second term,

-- the second input (E2) of the rating unit (BE) is a source connection of the second inverter stage (n2, $p_2$),

-- the first inverter stage ($n_1$, $p_1$) and the second inverter stage ($n_2$, $p_2$) are coupled to one another, an output (50) of the first inverter stage ($n_1$, $p_1$) being connected to an input (52) of the second inverter stage ($n_2$, $p_2$) and an output (51) of the second inverter stage ($n_2$, $p_2$) being connected to an input (53) of the first inverter stage ($n_1$, $p_1$),

-- a reset unit (5) is provided for equalizing a potential difference between an output potential (A) of the first inverter stage ($n_1$, $p_1$) and an output potential ($\bar{A}$) of the second inverter stage ($n_2$, $p_2$), and

-- the output potential (A) of the first inverter stage ($n_1$, $p_1$) describes a result for comparison of the first parallel-path current ($I_1$) with the second parallel-path current ($I_2$).

2. Circuit arrangement according to Claim 1, in which the reference unit (RE) has at least one reference transistor, one connection (60) of which is coupled to the second input (E2) of the rating unit (BE).

3. Circuit arrangement according to Claim 1 or 2, in which the transistor unit (TE) is provided for a plurality of comparisons by a plurality of rating units.

4. Binary full adder cell having a circuit arrangement according to one of Claims 1 to 3.

5. Binary multiplier cell having a circuit arrangement according to one of Claims 1 to 3.

6. Field multiplier having a plurality of multiplier cells according to Claim 5.

**Revendications**

1. Circuit permettant de réaliser des éléments logiques

   - dans lequel est prévue une unité de transistors (TE) avec au moins un transistor (T1, T2, T3, ..., Tn), les transistors (T1, T2, T3, ..., Tn) étant dimensionnés de telle sorte que les courants transversaux ( $It_1$, $It_2$, $It_3$, ..., $It_n$) qui traversent les transistors (T1, T2, T3, ..., Tn) représentent chacun un opérande d'un premier terme d'une équation de valeurs seuils,
   - dans lequel est prévue une unité de référence (RE) qui délivre un deuxième terme de l'équation de valeurs seuils,
   - dans lequel est prévue une unité d'évaluation (BE) pour la comparaison du premier au deuxième terme,
   - dans lequel tous les transistors de l'unité de transistors (TE) sont montés en parallèle et sont reliés, par l'intermédiaire d'une sortie (ATE) de l'unité de transistors (TE), à une première entrée (E1) de l'unité d'évaluation (BE),
   - dans lequel une sortie de l'unité de référence (RE) est reliée à une deuxième entrée (E2) de l'unité d'évaluation (BE),

   **caractérisé par le fait**

   - que l'unité d'évaluation (BE) comprend un circuit pour la comparaison de deux grandeurs électriques,

     - - un premier étage inverseur ($n_1$, $p_1$), constitué de transistors MOS à effet de champ, étant prévu, à travers lequel circule un premier courant transversal ($I_1$) dont la valeur représente la valeur du premier terme,
     - - la première entrée (E1) de l'unité d'évaluation (BE) étant une borne de source du premier étage inverseur ($n_1$, $p_1$),
     - - un deuxième étage inverseur ($n_2$, $p_2$), constitué de transistors MOS à effet de champ, étant prévu, à travers lequel circule un deuxième courant transversal ($I_2$) dont la valeur représente la valeur du deuxième terme,
     - - la deuxième entrée (E2) de d'évaluation (BE) étant une borne de source du deuxième étage inverseur ($n_2$, $p_2$),
     - - le premier étage inverseur ($n_1$, $p_1$) et le

deuxième étage inverseur ($n_2$, $p_2$) étant couplés l'un à l'autre,

     une sortie (50) du premier étage inverseur ($n_1$, $p_1$) étant reliée à une entrée (52) du deuxième étage inverseur ($n_2$, $p_2$) et une sortie (51) du deuxième étage inverseur ($n_2$, $p_2$) étant reliée à une entrée (53) du premier étage inverseur ($n_1$, $p_1$),

     - - une unité de réinitialisation (5) étant prévue pour compenser une différence de potentiel entre un potentiel de sortie (A) du premier étage inverseur ($n_1$, $p_1$) et un potentiel de sortie ($\bar{A}$) du deuxième étage inverseur ($n_2$, $P_2$) et
     - - le potentiel de sortie (A) du premier étage inverseur ($n_1$, $p_1$) décrivant un résultat de la comparaison entre le premier courant transversal ($I_1$) et le deuxième courant transversal ($I_2$).

2. Circuit selon la revendication 1 dans lequel l'unité de référence (RE) comporte au moins un transistor de référence qui est couplé à une borne (60) de la deuxième entrée (E2) de l'unité d'évaluation (BE).

3. Circuit selon la revendication 1 ou 2 dans lequel l'unité de transistors (TE) est prévue pour plusieurs comparaisons à l'aide de plusieurs unités d'évaluation (BE).

4. Cellule binaire d'addition complète avec un circuit selon l'une des revendications 1 à 3.

5. Cellule binaire de multiplication avec un circuit selon l'une des revendications 1 à 3.

6. Multiplicateur de champ avec plusieurs cellules de multiplication selon la revendication 5.

FIG 1

FIG 2

FIG 3

EP 0 834 115 B1

FIG 4

FIG 5

$V_{DD}$ R $V_{DD}$ $V_{DD}$

$\overline{y}$

$y = a + b + c + d + e$

a | 1  b | 1  c | 1  d | 1  e | 1

0,5

FIG 11a

$a_1$

clk2

$ona_1$

FIG 11b

$a_2$

clk2

clk1

clk2

$ona_2$

FIG 11c

$a_2$

clk2

clk1

$oa_2$

FIG 6

EP 0 834 115 B1

FIG 7

$V_{DD}$  clk1  $V_{DD}$  $V_{DD}$  $V_{DD}$  clk2  $V_{DD}$  clk1  $V_{DD}$

s

$a_2$  b  c

M2  M3  M4

$a_1$

M1

clk2

nü

2  1  1  1,5  2  0,5

FIG 8

EP 0 834 115 B1

FIG 9

FIG 10

EP 0 834 115 B1